# FASCICULE DE BREVET EUROPEEN

(11) **EP 1 263 042 B1**
(45) Date de publication et mention de la délivrance du brevet: **13.08.2008**
(21) Numéro de dépôt: 02291293.5
(22) Date de dépôt: 28.05.2002
(51) Int. Cl.: H01L 23/495, H01L 23/31

(54) **Boîtier semi-conducteur à grille évidée et grille évidée**
Halbleiterverpackung mit ausgespartem Leiterrahmen und ausgesparter Leiterrahmen
Semiconductor package with recessed lead frame and recessed lead frame

(30) Priorité: 31.05.2001 FR 0107185
(43) Date de publication de la demande: 04.12.2002
(73) Titulaire: STMicroelectronics S.A., 92120 Montrouge (FR)
(72) Inventeur: Diot, Jean-Luc, 38000 Grenoble (FR)
(74) Mandataire: Casalonga, Axel

(56) Documents cités:
- EP-A- 0 989 608
- US-A- 4 680 613
- US-A- 6 011 303
- US-A- 6 025 640
- PATENT ABSTRACTS OF JAPAN vol. 1997, no. 03, 31 mars 1997 (1997-03-31) -& JP 08 306853 A (FUJITSU LTD), 22 novembre 1996 (1996-11-22)
- CHA K-B ET AL: "ULTRA-THIN AND CRACK-FREE BOTTOM LEADED PLASTIC (BLP) PACKAGE DESIGN" PROCEEDINGS OF THE ELECTRONIC COMPONENTS AND TECHNOLOGY CONFERENCE. LAS VEGAS, MAY 21 - 24, 1995, NEW YORK, IEEE, US, vol. CONF. 45, 21 mai 1995 (1995-05-21), pages 224-228, XP000624973 ISBN: 0-7803-2737-3
- PATENT ABSTRACTS OF JAPAN vol. 011, no. 306 (E-546), 6 octobre 1987 (1987-10-06) -& JP 62 098751 A (TOSHIBA CORP), 8 mai 1987 (1987-05-08)

## Description

La présente invention concerne le domaine des boîtiers semiconducteurs dans lesquels une grille en un matériau conducteur de l'électricité comprend une plateforme sur la face avant de laquelle est fixée une puce de circuits intégrés et des pattes périphériques dont la face avant est reliée à la puce par des fils de connexion électrique, cet ensemble étant encapsulé par exemple dans une résine thermo-durcissable de telle sorte que la face arrière de la grille soit visible de façon à pouvoir connecter extérieurement la face arrière desdites pattes.

Lorsqu'on souhaite fixer sur la plateforme de la grille une puce de dimensions réduites, on est obligé de prévoir des fils de connexion électrique de longueurs accrues. Cette augmentation de la longueur des fils de connexion électrique engendre un accroissement des résistances électriques parasites. Pour limiter cette résistance électrique parasite, on peut prévoir de réduire la surface de la plateforme et de rallonger vers l'intérieur les pattes de connexion électrique. Une telle disposition engendre cependant des difficultés d'ancrage des pattes de connexion électrique dans la résine d'encapsulation et n'assure pas une délimitation réduite de la zone de la face arrière des pattes sur laquelle sera effectuée ultérieurement la connexion électrique extérieure.

Le document EP-A-989 608 et le document US-A-6 025 640 décrivent des boîtiers semi-conducteur qui comprennent une grille dont les pattes de connexion électrique en partie noyées dans une matière d'enrobage et présentant des parties intérieures en porte-à-faux sur la face avant desquelles sont soudés des fils de connexion électrique.

Plus spécifiquement, ce document décrit un boîtier semi-conducteur comprenant une grille plate en un matériau conducteur de l'électricité présentant une face avant et une face arrière et constituant une plateforme centrale et des pattes allongées de connexion électrique réparties autour de cette plateforme et présentant une extrémité intérieure située du côté de la puce et une extrémité extérieure, une puce de circuits intégrés fixée sur la face avant de ladite plateforme, des fils de connexion électrique reliant ladite puce et la face avant desdites pattes, ainsi que des moyens d'encapsulation tels que la face arrière de ladite grille est exposée, dans lequel lesdites pattes de connexion électrique comprennent une partie d'extrémité intérieure et une partie d'extrémité extérieure, la face arrière de la partie d'extrémité extérieure est située dans le plan de la face arrière de ladite grille, la face arrière de la partie d'extrémité intérieure est en retrait par rapport au plan de la face arrière de ladite plateforme central de façon à déterminer un évidement arrière, lesdits fils de connexion électrique étant connectés auxdites pattes sur la face avant de leur partie d'extrémité intérieure.

La présente invention a pour but de proposer un boîtier semi-conducteur et une grille de connexion électrique permettant de limiter les inconvénients indiqués ci-dessus.

La présente invention a tout d'abord pour objet un boîtier semi-conducteur qui comprend une grille plate en un matériau conducteur de l'électricité présentant une face avant et une face arrière et constituant une plateforme centrale et des pattes allongées de connexion électrique réparties autour de cette plateforme et présentant une extrémité intérieure située du côté de la puce et une extrémité extérieure, une puce de circuits intégrés fixée sur la face avant de ladite plateforme, des fils de connexion électrique reliant ladite puce et la face avant desdites pattes, ainsi que des moyens d'encapsulation tels que la face arrière de ladite grille est visible.

Selon l'invention, lesdites pattes de connexion électrique comprennent une partie d'extrémité intérieure et une partie d'extrémité extérieure dont les faces arrière sont situées dans le plan de la face arrière de ladite grille et qui sont reliées par une branche dont la face arrière est en retrait par rapport au plan de la face arrière de ladite grille de façon à déterminer un évidement arrière, lesdits fils de connexion électrique étant connectés auxdites pattes sur la face avant de leur partie d'extrémité intérieure.

Selon l'invention, lesdits moyens d'encapsulation comprennent de préférence un matériau d'enrobage qui s'étend, à partir de la face arrière de ladite grille, au moins entre lesdites pattes et entre ces pattes et ladite plateforme.

Selon l'invention, lesdites pattes comprennent de préférence un passage au travers duquel s'étend ledit matériau d'enrobage.

Selon une variante de l'invention, ledit matériau d'enrobage constitue, en avant de ladite grille, un bloc dans lequel sont noyés ladite puce et lesdits fils de connexion électrique.

Selon une autre variante de l'invention, ledit matériau d'enrobage constitue, en avant de ladite grille, un anneau en saillie s'étendant à l'extérieur de la zone de soudage des fils électrique sur les parties d'extrémité intérieure desdites pattes et qu'il comprend une plaque dont la périphérie est fixée sur la partie avant dudit anneau, de façon à fomer une cavité entre cette plaque et ladite grille.

Selon l'invention, lesdites pattes et ladite plateforme comprennent de préférence, sur au moins une partie de la périphérie de leurs faces arrière, des bords chanfeinés ou creusés.

La présente invention a également pour objet une grille plate en un matériau conducteur de l'électricité présentant une face avant et une face arrière et constituant une plateforme centrale et des pattes allongées réparties autour de cette plateforme et présentant une extrémité intérieure située du côté de la puce et une extrémité extérieure.

Selon l'invention, lesdites pattes de connexion électrique comprennent une partie d'extrémité intérieure et une partie d'extrémité extérieure dont les faces arrière sont situées dans le plan de la face arrière de ladite grille et qui sont reliées par une branche dont la face arrière est en retrait par rapport au plan de la face arrière de ladite grille de façon à déterminer un évidement arrière.

Selon l'invention, lesdites pattes et ladite plateforme comprennent de préférence, sur au moins une partie de la périphérie de leurs faces arrière, des bords chanfeinés ou creusés.

Selon l'invention, lesdites branches desdites pattes présentent de préférence des passages ou trous traversants.

La présente invention sera mieux comprise à l'étude de boîtiers semi-conducteurs décrits à titre d'exemples non limitatifs et illustrés par le dessin sur lequel :
- la figure 1 présente une coupe transversale d'un boîtier semi-conducteur selon la présente invention ;
- la figure 2 représente une vue arrière du boîtier semi-conducteur de la figure 1 ;
- la figure 3 représente une vue arrière partielle de la grille du boîtier semi-conducteur de la figure 1 ;
- la figure 4 représente une coupe transversale de plusieurs boîtiers semi-conducteurs correspondant à celui de la figure 1, à une étape de fabrication ;
- la figure 5 représente une coupe transversale de plusieurs boîtiers semi-conducteurs correspondant à celui de la figure 1, à une autre étape de fabrication ;
- et la figure 6 représente une coupe transversale d'un autre boîtier semi-conducteur selon la présente invention.

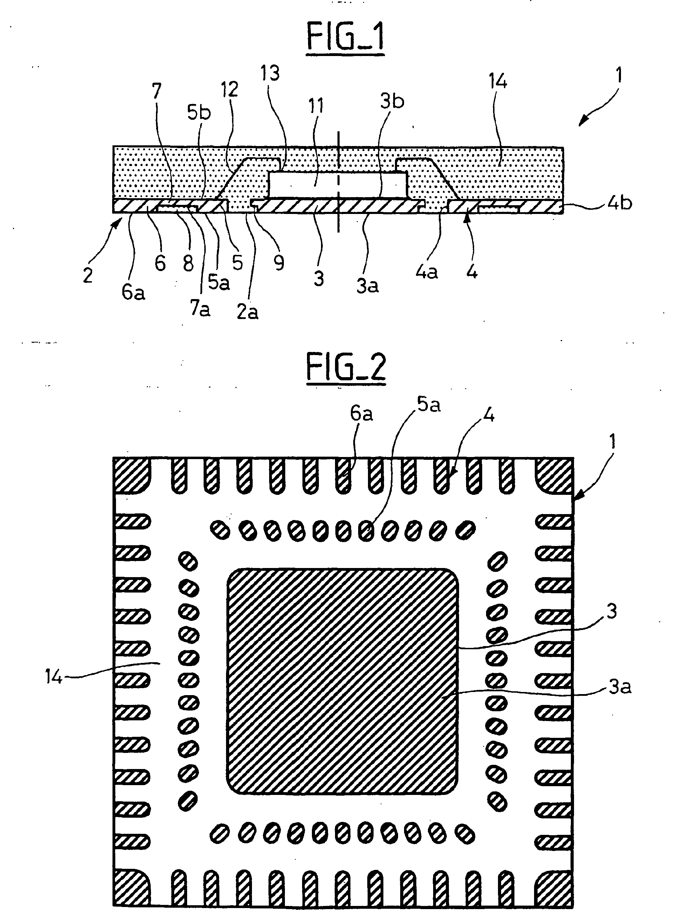

En se reportant aux figures 1 à 3, on voit qu'on a représenté un boîtier semi-conducteur 1 qui comprend une grille plate 2 en un matériau conducteur de l'électricité, par exemple métallique, qui présente, dans sa partie centrale, une plateforme 3 carrée et une multiplicité de pattes de connexion électrique allongées 4 qui sont réparties autour.

Ces pattes de connexion électrique allongées 4 sont distantes les unes des autres et sont placées à distance de la plateforme 3 de façon à présenter une extrémité intérieure 4a située du côté de la plateforme 3 et une extrémité extérieure 4b, les extrémités intérieures 4a s'étendant selon un carré situé à distance de la périphérie de la plateforme 3 et les extrémités extérieures 4b s'étendant selon un carré extérieur.

Les pattes de connexion électrique 4 présentent respectivement une partie d'extrémité intérieure 5 située du côté de la plateforme 3 ou adjacente à leur extrémité intérieure 4a, une partie d'extrémité extérieure 6 distante de leurs parties intérieures 5 et adjacentes à leur extrémité extérieure 4b et une branche 7 qui relie leur partie d'extrémité intérieure 5 et leur partie d'extrémité extérieure 6.

Les parties d'extrémité intérieures 5 et les parties d'extrémité extérieures 6 des pattes de connexion électrique 4 présentent respectivement des faces arrière 5a et 6a qui s'étendent dans le plan arrière 2a de la grille 2, tandis que leurs branches 7 présentent des faces arrière 7 en retrait par rapport au plan arrière 2a de la grille 2 de façon à constituer des évidements arrière 8.

La face arrière 3a de la plateforme 3 s'étend également dans le plan arrière 2a de la grille 2.

La plateforme 3 et les parties extérieures 6 des pattes de connexion électrique 4 présentent, à la périphérie de leurs faces arrière situées dans le plan arrière 2a de la grille 2, des bords chanfreinés ou creusés 9 et 10.

Le boîtier semi-conducteur 1 comprend également une puce de circuits intégrés 11 dont la face arrière est fixée sur la face avant 3b de la plateforme 3 de la grille 2 et des fils de connexion électrique 12 dont une extrémité est soudée sur des plots 13 de la face avant de la puce 11, les autres extrémités des fils sont soudées sur la face avant 5b des parties intérieures 5 des pattes de connexion électrique 4.

Le boîtier semi-conducteur 1 comprend en outre un bloc d'encapsulation 14 en un matériau d'enrobage, par exemple en une résine thermodurcissable.

Ce bloc d'encapsulation 14 détermine un parallélépipède qui s'étend en avant de la face arrière 2a de la grille 2 de façon à noyer cette grille 2, la puce 11 et les fils de connexion électrique 12 et de telle sorte que la face arrière 3a de la plateforme 3 et les faces arrière Sa et 6a des parties intérieures et extérieures 5 et 6 des pattes de connexion électrique 4 soient apparentes ou visibles.

Il en résulte que le bloc d'encapsulation remplit les espaces séparant la plateforme 3 et les pattes de connexion électrique 4, les espaces entre les pattes de connexion électrique 4, les évidements arrière 8 des pattes de connexion électrique 4 et les bords chanfreinés ou creusés 9 et 10 de la plateforme 3 et des pattes de connexion électrique 4 de telle sorte que la grille 2 est maintenue ou ancrée solidement.

Ainsi, les faces arrière 6a des parties extérieures 6 des pattes de connexion électrique 4 de la grille 2 sont de dimensions réduites et peuvent avantageusement être utilisées pour réaliser les connexions électriques extérieures du boîtier semi-conducteur 1.

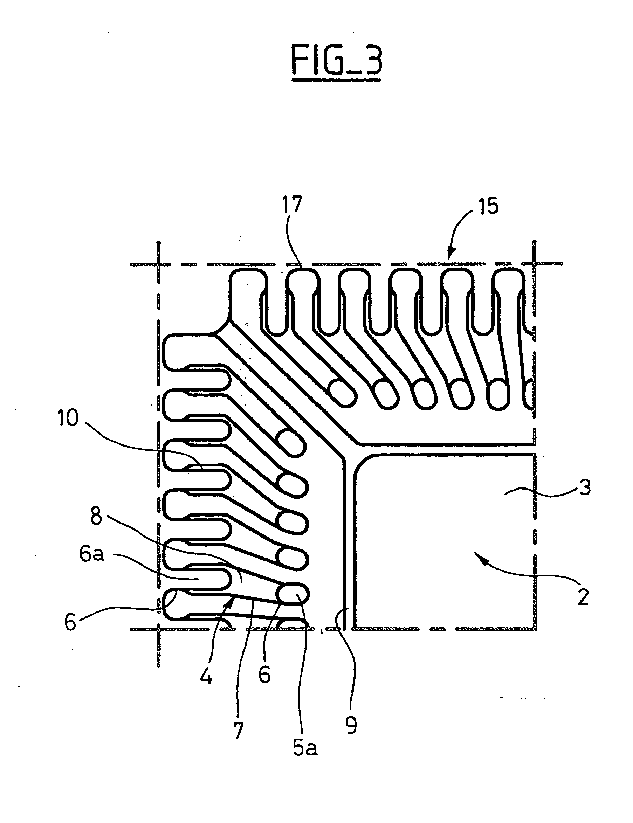

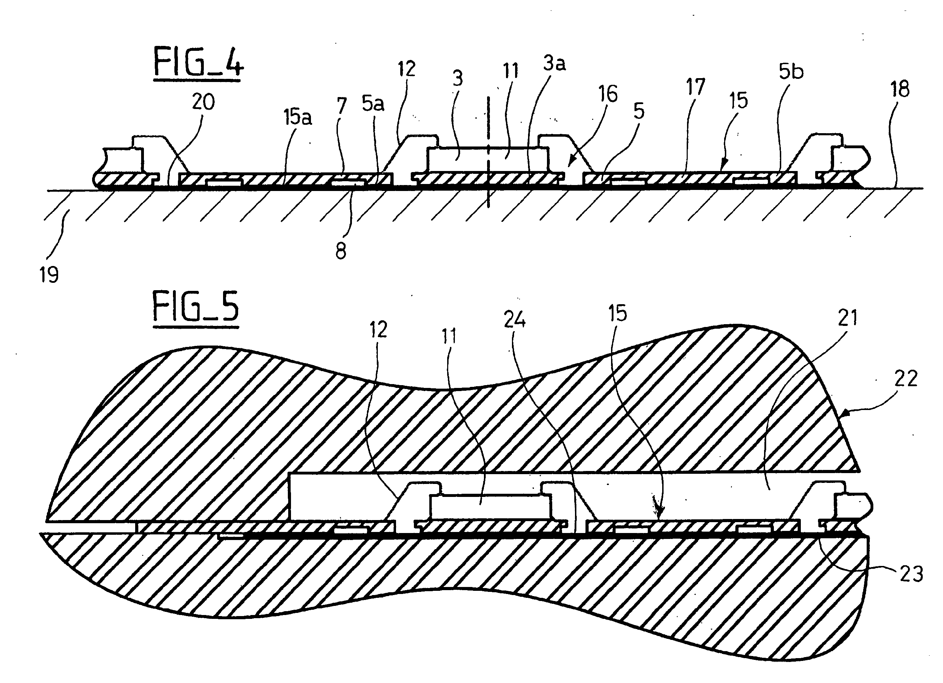

En se reportant aux figures 3 et 4, on voit qu'on a représenté une plaque métallique 15 qui comprend une multiplicité de zones 16 correspondant respectivement à la grille 2 et reliées entre elles par des bandes 17. La face arrière 15a de la plaque 15 est fixée sur une surface plate 18 d'un support 19 par l'intermédiaire d'une bande adhésive 20, de telle sorte que les faces arrière 3a des plateformes 3 et les faces arrière 5a et 6a des parties intérieures et extérieures 5 et 6 des pattes de connexion électrique 4 des différentes grilles 2 formées dans les zones 16 sont en appui sur la surface 18 du support 19 par l'intermédiaire du ruban adhésif 20.

La plaque 15 étant ainsi installée et maintenue, on peut alors fixer les différentes puces 11 sur les différentes plateformes 3 et souder les extrémités des différents fils de connexion électrique 12, sans que les plateformes 3 et les parties intérieures 5 des pattes de connexion électrique ne se déplacent.

Après quoi, comme le montre la figure 5, on peut placer la grille 15 munie des différentes puces 11 et des différents fils de connexion électrique 12 dans la cavité 21 d'un moule d'injection 22, en fixant la face arrière 15a contre une surface 23 de la cavité 21 également par l'intermédiaire d'une bande adhésive 24.

On procède alors à l'injection d'un matériau d'enrobage dans la cavité 21 du moule 22 qui va remplir cette cavité jusqu'à la face arrière 15a de la grille 15.

Après démoulage, on peut procéder au sciage du bloc moulé en éliminant les bandes 17, de façon à obtenir une multiplicité de boîtiers semi-conducteurs 1 tels que décrits précédemment et correspondant respectivement aux différentes zones 16 de la plaque 15.

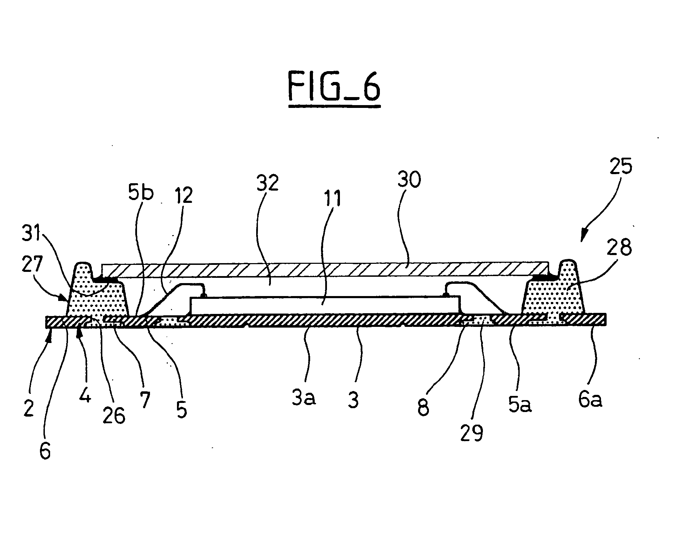

En se reportant à la figure 6, on voit qu'on a représenté un boîtier semi-conducteur 25 qui comprend, comme le boîtier semi-conducteur 1, une grille 2, une puce de circuits intégrés 11 et des fils de connexion électrique 12, les branches 7 des pattes de connexion électrique 4 présentant en outre des passages traversants 26.

Le boîtier semi-conducteur 25 se différencie du boîtier semi-conducteur 1 par le fait qu'il comprend un bloc d'encapsulation 27 en une matière d'enrobage, qui forme un anneau en saillie 28 qui s'étend en avant de la face avant de la grille 2, autour et à distance des zones de soudure des fils de connexion électrique 12 sur les faces frontales 5b des parties intérieures 5 des pattes de connexion électrique 4 et des parties de remplissage 29.

Le bloc d'encapsulation 27 en une matière d'enrobage remplit également, dans l'épaisseur de la grille 2, les espaces séparant les pattes de connexion électrique 4 et la plateforme 3, les espaces séparant les pattes de connexion électrique, les évidements arrière 8 des pattes de connexion électrique et les trous traversants 26 pour relier la matière remplissant les évidements 8 et l'anneau 28.

Le boîtier semi-conducteur 25 comprend en outre une plaque frontale d'encapsulation 30 dont la périphérie est fixée sur une face frontale 31 de l'anneau 28 par l'intermédiaire d'une colle, de façon à délimiter une cavité 32 enfermant la puce 11 et les fils de connexion électrique 12.

Pour fabriquer le boîtier semi-conducteur 25, on procède tout d'abord à la réalisation du bloc d'encapsulation 27 sur la grille 2.

Puis, on fixe la puce 11 et on soude les extrémités des fils de connexion électrique 12 comme décrit précédemment.

Enfin, on procède à l'installation de la plaque d'encapsulation 30.

Bien entendu, on peut aussi installer la grille 15 décrite en référence à la figure 4, réaliser en une seule opération de moulage des blocs d'encapsulation 25 sur les différentes zones 16, fixer des puces 11 sur les différentes plateformes 3, souder les fils de connexion électrique 12 sur les différentes puces 11 et respectivement les parties intérieures 5 des différentes pattes de connexion électrique 4, fixer différentes plaques 30 sur les différents anneaux 28, et enfin couper la plaque 15 de façon à supprimer les bandes 17. On obtient ainsi différents boîtiers semi-conducteurs 25 correspondant aux différentes zones 16.

La présente invention ne se limite pas aux exemples ci-dessus décrits. Bien, des variantes sont possibles sans sortir du cadre défini par les rendications annexées.

## Revendications

1. Boîtier semi-conducteur comprenant une grille plate en un matériau conducteur de l'électricité présentant une face avant et une face arrière et constituant une plateforme centrale et des pattes allongées de connexion électrique réparties autour de cette plateforme et présentant une extrémité intérieure située du côté de la puce et une extrémité extérieure, une puce de circuits intégrés fixée sur la face avant de ladite plateforme, des fils de connexion électrique reliant ladite puce et la face avant desdites pattes, ainsi que des moyens d'encapsulation tels que la face arrière de ladite grille est exposée
dans lequel lesdites pattes de connexion électrique (4) comprennent une partie d'extrémité intérieure (5) et une partie d'extrémité extérieure (6) dont les faces arrière (5a, 6a) sont situées dans le plan de la face arrière (2a) de ladite grille (2) et qui sont reliées par une branche (7) dont la face arrière est en retrait par rapport au plan de la face arrière de ladite grille de façon à déterminer un évidement arrière (8), lesdits fils de connexion électrique (12) étant connectés auxdites pattes (4) sur la face avant de leur partie d'extrémité intérieure (5b).

2. Boîtier selon la revendication 1, **caractérisé par le fait que** lesdits moyens d'encapsulation comprennent un matériau d'enrobage (14, 27) qui s'étend, à partir de la face arrière de ladite grille, au moins entre lesdites pattes et entre ces pattes et ladite plateforme.

3. Boîtier selon la revendication 2, **caractérisé par le fait que** lesdites pattes (4) comprennent un passage ou trou (26) au travers duquel s'étend ledit matériau d'enrobage.

4. Boîtier selon l'une des revendications 2 et 3, **caractérisé par le fait que** ledit matériau d'enrobage constitue, en avant de ladite grille, un bloc (14) dans lequel sont noyés ladite puce et lesdits fils électriques.

5. Boîtier selon l'une des revendications 2 et 3, **caractérisé par le fait que** ledit matériau d'enrobage constitue, en avant de ladite grille, un anneau en saillie (28) s'étendant à l'extérieur de la zone de soudage des fils de connexion électrique sur les parties d'extrémité intérieure desdites pattes et qu'il comprend une plaque (30) dont la périphérie est fixée sur la partie avant dudit anneau, de façon à fomer une cavité entre cette plaque et ladite grille.

6. Boîtier selon l'une quelconque des revendications précédentes, **caractérisé par le fait que** lesdites pattes et ladite plateforme comprennent, sur au moins une partie de la périphérie de leurs faces arrière, des bords chanfeinés ou creusés (9, 10).

7. Grille plate en un matériau conducteur de l'électricité présentant une face avant et une face arrière et constituant une plateforme centrale et des pattes allongées réparties autour de cette plateforme et présentant une extrémité intérieure située du côté de la plateforme et une extrémité extérieure, dans laquelle lesdites pattes de connexion électrique (4) comprennent une partie d'extrémité intérieure (5) et une partie d'extrémité extérieure (6) dont les faces arrière sont situées dans le plan de la face arrière de ladite grille et qui sont reliées par une branche (7) dont la face arrière est en retrait par rapport au plan de la face arrière de ladite grille de façon à déterminer un évidement arrière (8).

8. Grille selon la revendication 7, **caractérisé par le fait que** lesdites pattes et ladite plateforme comprennent, sur au moins une partie de la périphérie de leurs faces arrière, des bords chanfeinés ou creusés (9, 10).

9. Grille selon la revendication 7, **caractérisé par le fait que** lesdites branches (7) desdites pattes (4) présentent des passages ou trous traversants (26).

## Claims

1. Semiconductor package comprising a flat leadframe made of an electrically conductive material having a front face and a rear face and constituting a central platform and elongate electrical connection leads distributed around this platform and having an inner end located on the side towards the chip and an outer end, an integrated-circuit chip fastened to the front face of the said platform, electrical connection wires connecting the said chip to the front face of the said leads, together with encapsulation means such that the rear face of the said leadframe is exposed, in which the said electrical connection leads (4) comprise an inner end part (5) and an outer end part (6), the rear faces (5a, 6a) of which lie in the plane of the rear face (2a) of the said leadframe (2), which end parts are connected by a branch (7), the rear face of which is set back with respect to the plane of the rear face of the said leadframe so as to define a rear recess (8), the said electrical connection wires (12) being connected to the said leads (4) on the front face of their inner end part (5b).

2. Package according to Claim 1, **characterized in that** the said encapsulation means comprise an encapsulating material (14, 27) which extends, from the rear face of the said leadframe, at least between the said leads and between these leads and the said platform.

3. Package according to Claim 2, **characterized in that** the said leads (4) include a passage or hole (26) through which the said encapsulating material extends.

4. Package according to either of Claims 2 and 3, **characterized in that** the said encapsulating material constitutes, in front of the said leadframe, a block (14) in which the said chip and the said electrical wires are embedded.

5. Package according to either of Claims 2 and 3, **characterized in that** the said encapsulating material constitutes, in front of the said leadframe, a protruding ring (28) extending outside the region where the electrical connection wires are bonded to the inner end parts of the said leads and **in that** it includes a plate (30), the periphery of which is fastened to the front part of the said ring so as to form a cavity between this plate and the said leadframe.

6. Package according to any one of the preceding claims, **characterized in that** the said leads and the said platform have, over at least part of the periphery of their rear faces, chamfered or indented edges (9, 10).

7. Flat leadframe made of an electrically conductive material, having a front face and a rear face and constituting a central platform and elongate leads distributed around this platform and having an inner end located on the side towards the platform and an outer end, in which the said electrical connection leads (4) comprise an inner end part (5) and an outer end part (6), the rear faces of which lie in the plane of the rear face of the said leadframe, which end parts are connected by a branch (7), the rear face of which is set back with respect to the plane of the rear face of the said leadframe so as to define a rear recess (8).

8. Leadframe according to Claim 7, **characterized in that** the said leads and the said platform have, over at least part of the periphery of their rear faces, chamfered or indented edges (9, 10).

9. Leadframe according to Claim 7, **characterized in that** the said branches (7) of the said leads (4) have through-passages or through-holes (26).

## Patentansprüche

1. Halbleitergehäuse mit
einem flachen Leiterrahmen aus einem elektrisch leitenden Material, der eine vordere Fläche und eine hintere Fläche aufweist und eine zentrale Plattform und längliche elektrische Kontaktflecken bildet, die um diese zentrale Plattform herum verteilt angeordnet sind und ein zu der Seite des Chip hin gelegenes inneres Ende und ein äußeres Ende aufweisen,
einem an der Vorderfläche der Plattform angebrachten Chip mit integrierten Schaltungen,
elektrischen Anschlußdrähten, die den Chip und die Vorderfläche der Kontaktflecken verbinden, sowie
Verkapselungsmittel, derart, daß die hintere Fläche des Leiterrahmens frei liegt,
worin die elektrischen Kontaktflecken (4) einen inneren Endabschnitt (5) und einen äußeren Endabschnitt (6) aufweisen, deren hintere Flächen (5a,6a) in der Ebene der hinteren Fläche (2a) des Leiterrahmens (2) liegen und die mit einem Zweig (7) verbunden sind, dessen hintere Fläche bezüglich der Ebene der hinteren Fläche des Leiterrahmens versetzt angeordnet ist, um eine hintere Aussparung (8) zu definieren, wobei die elektrischen Anschlußdrähte (12) mit den Kontaktflecken (4) an der vorderen Fläche ihres inneren Endabschnitts (5b) verbunden sind.

2. Gehäuse nach Anspruch 1, **dadurch gekennzeichnet, daß** die Verkapselungsmittel ein Ummantelungsmaterial (14,27) aufweisen, das sich ausgehend von der hinteren Fläche des Leiterrahmens mindestens zwischen den Kontaktflecken und zwischen diesen Kontaktflecken und der Plattform erstreckt.

3. Gehäuse nach Anspruch 2, **dadurch gekennzeichnet, daß** die Kontaktflecken (4) einen Durchgang oder ein Loch (26) aufweisen, durch welches hindurch sich das Ummantelungsmaterial erstreckt.

4. Gehäuse nach einem der Ansprüche 2 und 3, **dadurch gekennzeichnet, daß** das Ummantelungsmaterial an der vorderen Seite des Leiterrahmens einen Block (14) bildet, in welchem der Chip und die elektrischen Drähte eingebettet sind.

5. Gehäuse nach einem der Ansprüche 2 und 3, **dadurch gekennzeichnet, daß** das Ummantelungsmaterial an der vorderen Seite des Leiterrahmens einen vorspringenden Ring (28) bildet, der sich außerhalb der Zone, in welcher die elektrischen Anschlußdrähte an den inneren Endabschnitten der Kontaktflecken angelötet sind, erstreckt, und daß sie eine Platte (30) aufweist, deren Peripherie an dem vorderen Teil des Rings angebracht ist, um einen Hohlraum zwischen dieser Platte und dem Leiterrahmen zu bilden.

6. Gehäuse nach einem der vorstehenden Ansprüche, **dadurch gekennzeichnet, daß** die Kontaktflecken und die Plattform mindestens an einem Abschnitt der Peripherie ihrer hinteren Flächen abgeschrägte oder ausgehöhlte Ränder (9,10) aufweisen.

7. Leiterrahmen aus einem elektrisch leitenden Material, der eine vordere Fläche und eine hintere Fläche aufweist und eine zentrale Plattform und längliche Kontaktflecken bildet, die um diese Plattform herum verteilt angeordnet sind und ein zu der Seite der Plattform hin liegendes inneres Ende und ein äußeres Ende aufweisen, worin die elektrischen Kontaktflecken (4) einen inneren Endabschnitt (5) und einen äußeren Endabschnitt (6) aufweisen, deren hintere Flächen in der Ebene der hinteren Fläche des Leiterrahmens liegen und die über einen Zweig (7) verbunden sind, dessen hintere Fläche bezüglich der Ebene der hinteren Fläche des Leiterrahmens versetzt angeordnet ist, um eine hintere Aussparung (8) zu definieren.

8. Leiterrahmen nach Anspruch 7, **dadurch gekennzeichnet, daß** die Kontaktflecken und die Plattform an mindestens einem Teil der Peripherie ihrer hinteren Flächen abgeschrägte oder ausgehöhlte Ränder (9,10) aufweisen.

9. Leiterrahmen nach Anspruch 7, **dadurch gekennzeichnet, daß** die Zweige (7) der Kontaktflecken (4) Durchgänge oder hindurchgehende Löcher (26) aufweisen.
